# EUROPEAN PATENT SPECIFICATION

(11) **EP 2 007 179 B1**
(45) Date of publication and mention of the grant of the patent: **05.06.2013**
(21) Application number: 07737869.3
(22) Date of filing: 06.03.2007
(51) Int. Cl.: H05K 3/46, H05K 3/00, H05K 1/11

(54) **MULTILAYER CIRCUIT BOARD HAVING CABLE PORTION AND METHOD FOR MANUFACTURING SAME**
MEHRSCHICHTIGE LEITERPLATTE MIT KABELTEIL UND HERSTELLUNGSVERFAHREN DAFÜR
CARTE A CIRCUIT IMPRIME MULTICOUCHE AYANT UNE PARTIE DE CABLE ET SON PROCEDE DE FABRICATION

(30) Priority: 12.04.2006 JP 2006109776
(43) Date of publication of application: 24.12.2008
(73) Proprietor: Nippon Mektron, Limited, Minato-ku Tokyo 105-8585 (JP)
(72) Inventor: MATSUDA, Fumihiko, Tokyo 105-8585 (JP)
(74) Representative: Jenkins, Peter David
(86) International application number: PCT/JP2007/054322
(87) International publication number: WO 2007/116622

(56) References cited:
- EP-A1- 0 148 379
- JP-A- 07 212 046
- JP-A- 08 330 734
- JP-A- 2000 223 835
- JP-A- 2004 095 695
- US-A- 5 097 390
- US-A- 5 346 117

## Description

### Technical Field

The present invention relates to a multilayer circuit board having flexible cable portions and a method for manufacturing the same, and more specifically to a structure of a buildup-type multilayer circuit board equipped with flexible cable portions having a plurality of layers and a method for manufacturing the same.

### Background Art

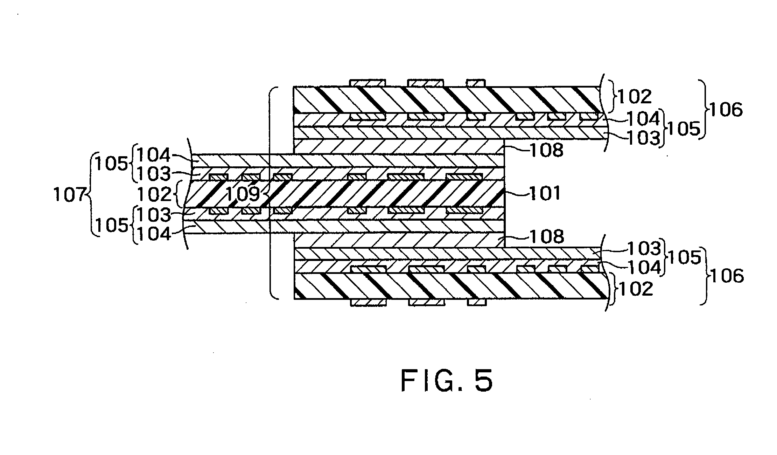

Figure 5 is a sectional view showing the main configuration of a conventional multilayer circuit board having cable portions drawn out of a plurality of layers. On a flexible insulating base material 101 of polyimide or the like, which is a basic material, layers to be the cable portions of a flexible circuit board 102 having circuit patterns including cable portions on both surfaces are disposed, and cover lays 105 having adhesive materials 104 on insulating films 103, such as polyimide films, are adhered onto the layers to be the cable portions to form cables for the outer-layer boards 106 and the inner-layer board 107 (refer to Patent Document 1).

The cables for the outer-layer boards 106 and the inner-layer board 107 are bonded by previously punched adhesive materials 108. For interlayer connection, through-holes penetrating all the layers, and blind via holes connecting nearby layers are used.

Aside from this, a method for manufacturing a thin multilayer flexible circuit board has also been provided (refer to Patent Document 2). This is for manufacturing a thin four-layer flexible circuit board by sharing the cover film for a flexible circuit board to become the cable portions of the inner-layer board with the base material for the outer-layer boards, that is, the flexible insulating base material.
Patent Document 1: Japanese Patent Publication No. 2-55958
Patent Document 2: Japanese Patent Laid-Open No. 5-90757

### Disclosure of the Invention

Among the above-described structures, what is described in Patent Document 1 has a problem in that since the configuration of the multilayer portion 109 is complicated and thick, the requirement for thickness reduction cannot be satisfied. In addition, when perforating conducting holes upon the formation of through-holes and blind via holes, there is another problem of dealing with the generation of a large quantity of foreign matter, such as the chips of materials for each layer and smear, in the conducting holes. Specifically, there are possibilities that the desmear processing for removing foreign matter, such as the chips, becomes complicated, and the lack of desmear processing causes defective electrical connection. Also, since the number of composing material is increased, there is a problem of increase in material costs.

Also in the method described in Patent Document 2, since the formation of outer-layer cables is difficult, it is still not easy to manufacture a thin multilayer flexible circuit board.

The present invention has been made in consideration of the above-described aspects, and it is an object of the present invention to provide a multilayer flexible circuit board that can be configured to be thin even when the board has cable portions drawn out of a plurality of outer layers; and a method for manufacturing the same.

A first aspect of the present invention provides a multilayer flexible circuit board, as defined in claim 1

A second aspect of the present invention provides a method for manufacturing a multilayer flexible circuit board, the method being as defined in claim 2

### Brief Description of the Drawings

Figure 1 is a side sectional view showing the configuration of an embodiment of the present invention;
Figure 2 is a process diagram showing the manufacturing process in an embodiment of the present invention;
Figure 3 is a process diagram showing the process following the process shown in Figure 2;
Figure 4 is a process diagram showing the process following the process shown in Figure 3; and
Figure 5 is a side sectional view showing the structure of a conventional multilayer circuit board.

### Description of Symbols

1 base material (flexible base material); 2 circuit board; 3 insulating film; 4 adhesive material; 5 cover lay; 6 outer-layer board (cable portion); 7 circuit board; 8 adhesive material; 9 inner-layer board (cable portion); 10 multilayer portion; 21 base material; 22, 23 copper foil; 24 conducting hole; 25 electrolytic-plated film; 26 through-hole; 27 circuit pattern; 28, 29 copper foil; 28a, 29a conformal mask; 30 double-sided copper clad laminate; 31, 31a, 31b conducting hole; 32 unnecessary adhesive material; 33 via hole; 34 step via hole; 35 skip via hole; 36 outer-layer circuit pattern; 37 multilayer circuit board; 101 base material; 102 double-sided circuit board; 103 insulating film; 104 adhesive material; 105 cover lay; 106 outer-layer board (cable); 107 inner-layer board (cable); 108 adhesive material; 109 multilayer portion

### Best Mode for Carrying Out the Invention

The embodiment of the present invention will be described below referring to the attached drawings.

### Embodiment 1

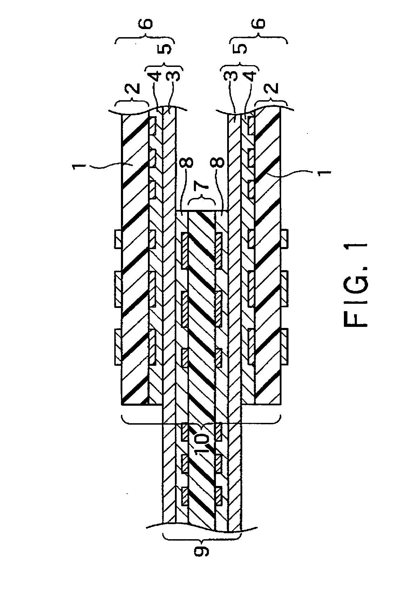

Figure 1 is a sectional view showing the structure of a multilayer flexible circuit board being Embodiment 1 of the present invention. This shows circuit boards 2 where circuit patterns including cable portions are formed on flexible insulating base materials 1, which are base materials. The circuit boards 2 are used as outer-layer boards.

Next, cover lays 5 wherein an adhesive material 4 is overlaid on each of insulating films 3, such as polyimide, are adhered onto either upper or lower surfaces, shown in the drawing, of the circuit boards 2. Thereby, two outer-layer boards 6 having cables composed of circuit boards 2 and cover lays 5 are prepared.

On the other hand, a double-sided inner-layer board 9 having circuit patterns on the upper and lower surfaces, shown in the drawing, of the base material is prepared. Then, in the state wherein cover lays 5 are inserted, the outer-layer boards 6 are adhered onto both surfaces, shown in the drawing, of the inner-layer board 9.

Previously punched adhesives 8 are adhered onto the inner-layer board 9, and the insulating films 3 of the cover lays 5 are adhered by the adhesives 8 to form the cover lays 5. Then, the outer-layer boards 6 are continuously joined to the inner-layer board 9 by the cover lays 3. Thereby, the multilayer portion wherein the outer-layer boards 6 and the inner-layer board 9 are laminated is configured to be thin.

The portions drawn out of both the outer-layer boards 6 and the inner-layer board 9 are used as flexible cables, and the portions are drawn out of at least one of the outer-layer boards 6 and the inner-layer board 9.

### Method for manufacturing Embodiment 1

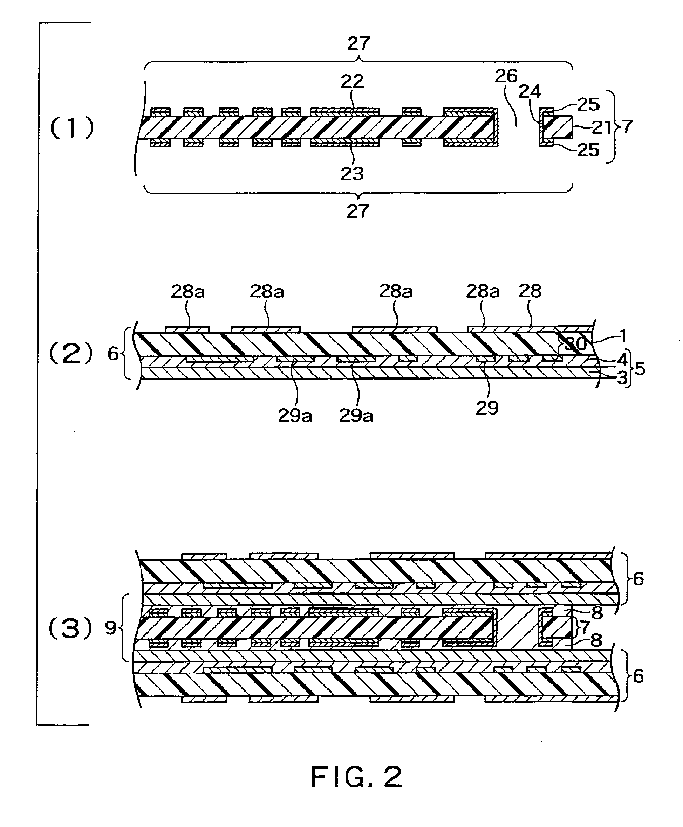

Figure 2 is process diagrams showing part of processes in the method for manufacturing Embodiment 1 shown in Figure 1. In Figure 2 (1), a conductive hole 24 is formed using an NC drill or the like in a base material 21 composed of a flexible insulating material, such as polyimide, of a thickness of for example, 25 µm having copper foils 22 and 23 of thickness of 8 µm on the both surfaces, which is called a double-sided copper clad laminate. Thereby, the inner-layer board 9 is formed.

Then, conducting treatment and subsequent electrolytic plating treatment are performed on the conductive hole 24 opened in the base material 21 to form an electrolytic-plated film 25 of about 10 µm, and an interlayer conducting path is formed. Thereby, a penetrating conductive hole 26 is formed.

Furthermore, circuit patterns on the both surfaces are subjected to a series of processes, such as resist layer formation, exposure, development, etching, and resist layer peeling using a photo fabrication method to form circuit patterns 27. Thereby, a double-sided inner-layer board 9 is formed.

Next, in Figure 2 (2), conformal masks 28a and 29a are formed on what is called a double-sided copper clad laminate 30 having copper foils 28 and 29 of a thickness of 12 µm on the both surfaces of a base material 1. This is performed using the above-described photo fabrication method to form circuit patterns on the copper foils 28 and 29.

At this time, since the alignment of the copper foils 28 and 29 are performed on the flat material, the alignment accuracy can be easily secured without being affected by the elongation and shrinkage of the material. As required, an exposing machine that can perform highly accurate alignment may be used. A roughening treatment for improving adhesion to the adhesive material may also be carried out.

On the other hand, what is called a cover lay 5 having an adhesive material 4, such as acryl and epoxy of a thickness of 15 µm on an insulating film 3, which is a polyimide film of a thickness of for example, 12 µm is prepared. Then, the cover lay 5 is adhered onto the inner-layer side of the buildup layer of the multilayer circuit board using a vacuum press, a laminator, or the like. Thereby, the outer-layer boards 6 with the cover lays 5 can be obtained.

Next, as shown in Figure 2 (3), adhesive materials 8 for laminating the outer-layer boards 6 on the inner-layer board 7 are aligned. The adhesive materials 8 are previously punched. Then, the outer-layer boards 6 with the cover lays 5 and the inner-layer board 7 are laminated with intervening adhesive materials 8 by the vacuum press or the like to form a multilayer circuit.

As the adhesive material, a material with little runoff, such as a low-flow type prepreg and a bonding sheet, is preferred. The thickness of the adhesive material 8 is preferably about 15 µm.

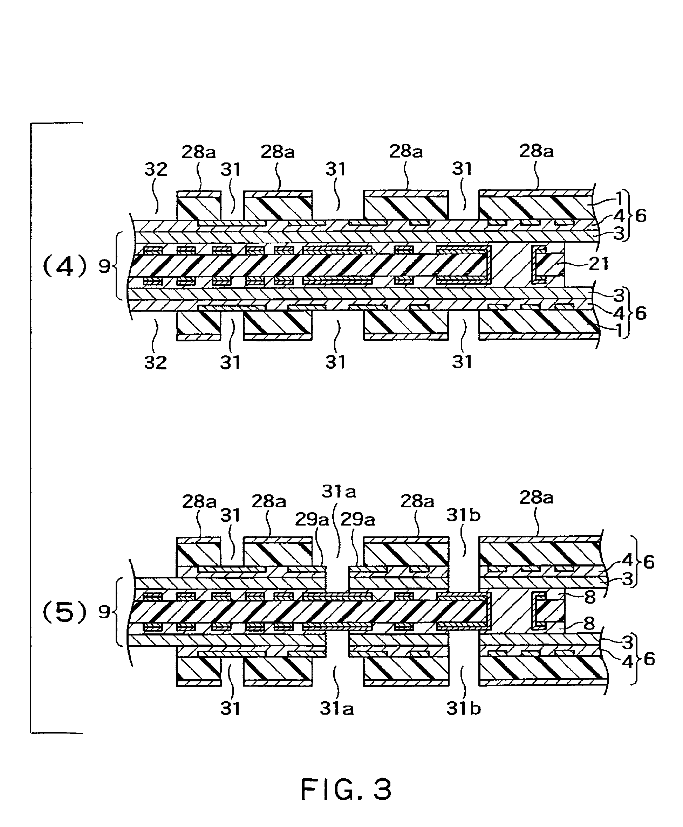

Figure 3 (4) shows a process for etching off the base materials 1 using the conformal masks 28a. In this process, the base materials 1 of the outer-layer boards 6 on the portions of the conductive holes 31 and the inner-layer boards 9 are removed.

As a resin etchant, a solution containing an alkali metal, an amine compound and water is preferred. By using such a resin etchant, the polyimide film of the base material 1, which is the flexible insulating base material can be selectively removed, and the adhesive material 4 of acryl, epoxy, or the like is little affected. Therefore, the polyimide film of the base material 1 to be removed can be subjected to resin etching without the shortage of etching.

When the resin etchant is used, a polyimide film for the base material 1 of the outer-layer boards 6 obtained by the polycondensation of pyromellitic dianhydride and aromatic diamine having high etching rate (for example, Kapton manufactured by du Pont and Apical manufactured by Kaneka Corporation) is preferred.

For the insulating film 3 of the base material 21 for the inner-layer board 9 and the cover lay 5, a polyimide film obtained by the polycondensation of biphenyl tetracarbonic dianhidride and diaminobenzene (for example, Upilex manufactured by Ube Industries, Ltd.) is preferred.

Furthermore, for the insulating film 3 of the base material 21 for the inner-layer board 7 and the cover lay 5, a resin film having high resistance to the above-described resin etchant, such as aramid resin may be used instead of polyimide.

In Figure 3 (5), step via holes and skip via holes are formed in the cover lays 5 and the adhesive materials 8 exposed from the conductive holes 31 processed in resin etching.

At locations to form these holes, laser processing is performed using previously prepared conformal masks 28a and 29a to form three kinds of conductive holes 31, 31a and 31b. The laser method may be selected from UV-YAG laser, carbon dioxide laser, excimer laser or the like.

The diameters of respective conductive holes 31, 31a and 31b are determined as follows: Firstly, the diameter of the conductive holes 31 is determined to be 50 µm, because when polyimide of a thickness of 25 µm is used for the base material 1, conductive holes having a diameter of 50 µm can be fabricated, and the plating thickness required for securing reliability is about 10 µm.

For conductive holes 31a and 31b, no thickness-adding plating of 10 µm or more resulting in increase in the thickness of the conductive layers is required from the second layer to the fifth layer of the layers composing outer-layer boards 6, and the thickness of the conductive layers can be reduced. For this reason, the thickness of the adhesive materials 4 and 8 required for filling can be reduced, and reliability can be secured even if the plating is relatively thin.

As the hole diameter that can secure reliability when plating thickness is about 15 to 20 µm, if the upper hole diameter is 150 µm and the lower hole diameter is 150 µm in the conductive holes 31a, minute wirings can be formed and the degree of integration can also be improved. Further, desmear treatment and conduction treatment for performing the interlayer connection by electrolytic plating are carried out. For processing using a conformal mask, a direct laser method may also be combined. When the direct laser method is used, the thickness of the copper foil is preferably 20 µm or less.

In addition, unnecessary adhesive materials 32 on the inner-layer board 9 can also be removed by laser processing. The kind of laser used in this case is preferably excimer laser, which excels in processing accuracy in the depth direction.

If carbon dioxide laser or UV-YAG laser is used from the point of view of productivity, the energy outputs and the numbers of shots of the laser are controlled for the accurate processing in the depth direction. This processing is preferably carried out under conditions different from the conditions for processing conductive holes.

Particularly when carbon dioxide laser is used, highly accurate processing in the depth direction is difficult to carry out. Therefore, it is preferable to leave remaining films having a thickness of about 5 µm, and simultaneously remove unnecessary matter using desmear process to remove remaining films and smear on the bottoms of conductive holes. The desmear process is performed using plasma and permanganic acid.

However, when requirement for bending is not so strict, such as cables bent only when assembling into the device, it is not required to remove unnecessary adhesive materials adhered onto the outer-layer board. In this case, it is preferable to prevent the adhesion of foreign matter produced by various shields, such as silver shield films and paste, to the exposed adhesive materials so as not to cause contamination.

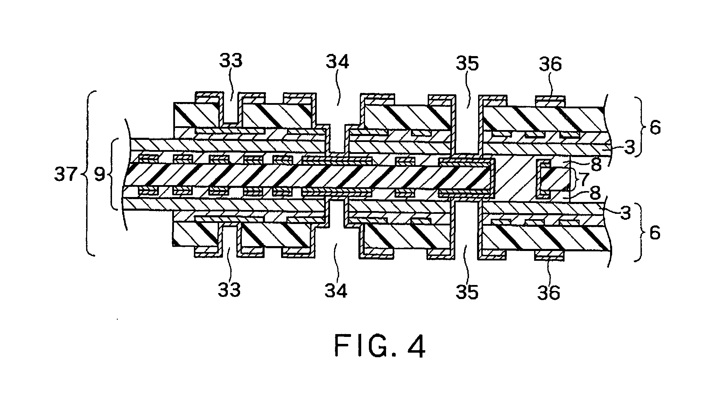

In the process shown in Figure 4, the multilayer circuit base material having conductive holes 31, 31a and 31b is subjected to electrolytic plating of about 15 to 20 µm to achieve interlayer conduction. By these processes, skip via holes 35 obtained from conductive holes 31 can be formed, and the interlayer conduction of all the circuits from the outer-layer boards to the inner-layer board in the buildup board can be achieved. Also in these processes, a multilayer circuit base material wherein interlayer conduction has been completed is obtained.

When through-holes for mounting inserting parts or the like is required, through-holes may be formed using an NC drill or the like at the time of forming conductive holes, and the through-holes may also be simultaneously formed at the time of via hole plating.

Furthermore, circuit patterns 36 for the outer-layer boards are formed using a normal photo fabrication method. At this time, plating layers deposited on the cover films 3 located in the inner-layer side of the laminated board are also removed, if any.

Thereafter, by performing surface treatment, such as solder plating, nickel plating and gold plating, on the surface of the board, and performing the formation and shape processing of a photo solder resist layer as required, a multilayer circuit board 37 having cables drawn out of the outer-layer boards 6 and the inner-layer board 7 can be formed.

To the processes shown in Figure 2 (1) to Figure 4, the role-to-role method can be applied, and further improvement of productivity can be expected. In addition to high-density mounting, examples wherein a multilayer circuit board having cable portions in the inner-layer board and the outer-layer board include the followings.

The multilayer flexible circuit board enabling high-density mounting for digital video cameras can mount a CSP (chip size package), and requires cables that are repeatedly bent and cables from other layers to be bent when assembled in the housing.

In the present invention, the requirements can be fully satisfied by using cables in the outer-layer board 6 as cables for repeated bending, and using cables in the inner-layer board 7 in combination as cables from other layers to be bent when assembled in the housing.

According to the present invention, as described, since the circuit provided on one of the base materials of the outer-layer boards and the inner-layer board of which cable portions can be drawn out composes the multilayer flexible circuit board coated by the cover common to the cable portions, the laminate structure can be simplified, and the multilayer flexible circuit board having a reduced thickness can be provided. In addition, since material costs can be reduced, the cost reduction effect can be obtained.

As a result of simplifying the board structure, the method for manufacturing a multilayer flexible circuit board wherein manufacturing processes are simplified can be provided. When via holes for connecting the outer-layer boards to the inner-layer board, since mask holes for forming conductive holes in the circuit pattern are provided, and the conductive holes are formed using the mask holes, highly reliable conductive holes integrated with the circuit pattern can be obtained.

## Claims

1. A multilayer flexible circuit board comprising a parts mounting portion composed by laminating an inner-layer board (9) and outer-layer boards (6), and cable portions having respective cables drawn out of both said inner-layer board (9) and at least one of the outer-layer boards (6), wherein each of said inner-layer board (9) and said outer-layer boards (6) has circuits facing one another, **characterized in that**
said circuits facing one another on the inner-layer board (9) and on the one of the outer-layer boards (6) are covered by an insulating film (3) that covers said cable portion drawn out of said inner-layer board (9) and the cable portion drawn out of said one of the outer-layer boards (6).

2. A method for manufacturing a multilayer flexible circuit board comprising a parts mounting portion having an inner-layer board (9) and outer-layer boards (6), laminated one another each having a base material (1) and conductive layers, and cable portions having respective cables drawn out of both said inner-layer board (9) and at least one of the outer-layer boards (6), wherein each of said inner-layer board (9) and said outer-layer boards (6) has circuits on both surfaces, **characterized by** comprising:
a process for preparing said inner-layer board (9) and said outer-layer boards (6) each having an insulating base material (7) and a conductive layer;
a process for forming a circuit pattern (27, 28a, 29a) having mask holes, for forming conducting holes (31, 31a, 31b), in the conductive layer in at least one of said inner-layer board (9) and outer-layer boards (6);
a process for adhering a cover lay (5) composed of an insulating film (3) and an adhesive material (4) onto said circuit pattern of said outer-layer boards (6);
a process for laminating the circuit pattern of said inner-layer board (9) and said outer-layer boards (6) via adhesive materials (4, 8) together with said cover lay sid (5) of said outer-layer boards (6), wherein said circuits facing one another on the inner-layer board (9) and on the one of the outer-layer boards (6) are covered by an insulating film (3) that covers said cable portion drawn out of said inner-layer board (9) and the cable portion drawn out of said one of the outer-layer boards (6);
a process for removing the base material (1) of said outer-layer boards (6) located in said cable portion drawn out of said inner layer board (9);
a process for performing hole-opening processing in said inner-layer board (9) using said mask holes to form conductive holes (31); and
a process for performing conductive treatment on said conducting holes (31, 31a, 31b) to form via holes (33, 34, 35).

3. The method for manufacturing a multilayer flexible circuit board according to claim 2, further comprising:
a process for removing the base material (1) of said outer-layer boards (6) using said mask holes by resin etching after laminating said inner-layer board (9) and said outer-layer boards (6).

4. The method for manufacturing a multilayer flexible circuit board according to claim 2, further comprising;
a process for forming mask holes together with a circuit pattern on said conductive layer in one of said outer-layer boards (6); and
a process for forming conductive holes in said inner-layer board (9) by laser processing using said mask holes after laminating said inner-layer board (9) and said outer-layer boards (6).

## Patentansprüche

1. Mehrschichtige flexible Leiterplatine, die einen Bauteilemontagebereich, der durch Laminieren von einer Innenschichtplatine (9) und Außenschichtplatinen (6) gebildet ist, und Kabelbereiche, die jeweilige Kabel aufweisen, die aus sowohl der Innenschichtplatine (9) und wenigstens einer der Außenschichtplatinen (6) hergezogen sind, aufweist, wobei jede der Innenschichtplatine (9) und der Außenschichtplatinen (6) einander gegenüberliegende Leiter aufweist, **dadurch gekennzeichnet,**
**dass** die sich auf der Innenschichtplatine (9) und auf der einen der Außenschichtplatinen (6) gegenüberliegenden Leiter durch eine Isolationsschicht (3) bedeckt sind, die den Kabelbereich, der aus der Innenschichtplatine (9) gezogen ist, und den Kabelbereich, der aus der einen der Außenschichtplatinen (6) gezogen ist, abdeckt.

2. Verfahren zum Herstellen einer mehrschichtigen flexiblen Leiterplatine, welche einen Bauteilemontagebereich, der eine Innenschichtplatine (9) und Außenschichtplatinen (6) aufweist, welche aufeinander laminiert sind, wobei jede ein Grundmaterial (1) und leitende Schichten aufweist, und einen Kabelbereich, der jeweilige Kabel aufweist, die aus sowohl der Innenschichtplatine (9) und aus wenigstens einer der Außenschichtplatinen (6) gezogen sind, aufweist, wobei jede der Innenschichtplatine (9) und der Außenschichtplatinen (6) auf beiden Oberflächen Leiter aufweist,
**dadurch gekennzeichnet, dass** es aufweist:
einen Prozess zum Bereitstellen der Innenschichtplatine (9) und der Außenschichtplatinen (6), wobei jede ein isolierendes Grundmaterial (7) und eine leitfähige Schicht aufweist;
einen Prozess zum Ausbilden eines Leitermusters (27, 28a, 29a), welches Maskenlöcher zum Ausbilden von Leitungslöchern (31, 31a, 31b) in der leitfähigen Schicht in wenigstens einer der Innenschichtplatine (9) und den Außenschichtplatinen (6) aufweist;
einen Prozess zum Ankleben einer Abdecklage (5), die aus einer Isolationsschicht (3) und einem Klebematerial (4) zusammengesetzt ist, auf den Leitermustern der Außenschichtplatinen (6);
einen Prozess zum Laminieren des Leitermusters der Innenschichtplatine (9) und der Außenschichtplatinen (6) mittels Klebematerialien (4, 8) zusammen mit der Ablecklagenseite (5) der Außenschichtplatinen (6), wobei die Leiter, die sich einander auf der Innenschichtplatine (9) und auf der einen der Außenschichtplatinen (6) gegenüberliegen, durch eine Isolationsschicht (3) bedeckt werden, die den Kabelbereich, der aus der Innenschichtplatine (9) gezogen ist, und den Kabelbereich, der aus der einen der Außenschichtplatinen (6) gezogen ist, abdeckt;
einen Prozess zum Entfernen des Grundmaterials (1) der Außenschichtplatinen (6), das sich in dem Kabelbereich befindet, der aus der Innenschichtplatine (9) gezogen ist;
einen Prozess zum Durchführen einer Lochöffnungsbearbeitung in der Innenschichtplatine (9) unter Verwendung der Maskenlöcher, um Leitungslöcher (31) auszubilden; und
einen Prozess zum Durchführen einer Leitungsbehandlung der Leitungslöcher (31; 31a, 31b), um Durchkontaktierungslöcher (33, 34, 35) auszubilden.

3. Verfahren zum Herstellen einer flexiblen Mehrschicht-Leiterplatine gemäß Anspruch 2, weiter aufweisend:
einen Prozess zum Entfernen des Grundmaterials (1) der Außenschichtplatinen (6) unter Verwendung der Maskenlöcher durch Harzätzen nach Laminieren der Innenschichtplatine (9) und der Außenschichtplatinen (6).

4. Verfahren zum Herstellen einer flexiblen Mehrschicht-Leiterplatine gemäß Anspruch 2, weiter aufweisend:
einen Prozess zum Ausbilden von Maskenlöchern zusammen mit einem Leitermuster auf der leitfähigen Schicht in einer der Außenschichtplatinen (6); und
einen Prozess zum Ausbilden von Leitungslöchern in der Außenschichtplatine (9) durch Laserbearbeitung unter Verwendung der Maskenlöcher nach Laminieren der Innenschichtplatine (9) und der Außenschichtplatinen (6).

## Revendications

1. Carte de circuit imprimé souple multicouche comprenant une partie montage de pièces composée en stratifiant une carte de couche intérieure (9) et des cartes de couches extérieures (6), et des parties câbles qui présentent des câbles respectifs qui sortent de ladite carte de couche intérieure (9) et de l'une au moins des cartes de couches extérieures (6), dans laquelle chacune de ladite carte de couche intérieure (9) et desdites cartes de couches extérieures (6) présente des circuits qui se font face les uns les autres, **caractérisée en ce que** :
lesdits circuits qui se font face les uns les autres sur la carte de couche intérieure (9) et sur l'une des cartes de couches extérieures (6) sont couverts par un film isolant (3) qui couvre ladite partie câble qui sort de ladite carte de couche intérieure (9) et la partie câble qui sort de ladite carte de couche extérieure (6).

2. Procédé de fabrication d'une carte de circuit imprimé souple multicouche qui comprend une partie montage de pièces qui présente une carte de couche intérieure (9) et des cartes de couches extérieures (6), stratifiées les unes avec les autres, chacune d'elles présentant un matériau de base (1) et des couches conductrices, et des parties câbles qui présentent des câbles respectifs qui sortent de ladite carte de couche intérieure (9) et de l'une au moins des cartes de couches extérieures (6), dans lequel chacune de ladite carte de couche intérieure (9) et desdites cartes de couches extérieures (6) présente des circuits qui se situent sur les deux surfaces, **caractérisé en ce qu'**il comprend :
un processus destiné à préparer ladite carte de couche intérieure (9) et lesdites cartes de couches extérieures (6), chacune d'elles présentant un matériau de base isolant (7) et une couche conductrice ;
un processus destiné à former un motif de circuit (27, 28a, 29a) qui présente des trous de masque, destiné à former des trous conducteurs (31, 31a, 31b), dans la couche conductrice dans l'une au moins de ladite carte de couche intérieure (9) et desdites cartes de couches extérieures (6) ;
un processus destiné à faire adhérer une couche de couverture (5) composée d'un film isolant (3) et d'un matériau adhésif (4) sur ledit motif de circuit desdites cartes de couches extérieures (6) ;
un processus destiné à stratifier le motif de circuit de ladite carte de couche intérieure (9) et desdites cartes de couches extérieures (6) par l'intermédiaire de matériaux adhésifs (4, 8) ainsi qu'une côté de ladite couche de couverture (5) desdites cartes de couches extérieures (6), dans lequel lesdits circuits qui se font face les uns les autres sur la carte de couche intérieure (9) et sur l'une des cartes de couches extérieures (6) sont couverts par un film isolant (3) qui couvre ladite partie câble qui sort de ladite carte de couche intérieure (9) et la partie câble qui sort de l'une desdites cartes de couches extérieures (6) ;
un processus destiné à retirer le matériau de base (1) desdites cartes de couches extérieures (6) situé dans ladite partie câble qui sort de ladite carte de couche intérieure (9) ;
un processus destiné à exécuter un traitement d'ouverture de trou dans ladite carte de couche intérieure (9) en utilisant lesdits trous de masque de façon à former des trous conducteurs (31) ; et
un processus destiné à exécuter un traitement conducteur sur lesdits trous conducteurs (31, 31a, 31b) de façon à former des trous traversants (33, 34, 35).

3. Procédé de fabrication d'une carte de circuit imprimé souple multicouche selon la revendication 2, comprenant en outre :
un processus destiné à retirer le matériau de base (1) desdites cartes de couches extérieures (6) en utilisant lesdits trous de masque par gravure de la résine après avoir stratifié ladite carte de couche intérieure (9) et lesdites cartes de couches extérieures (6).

4. Procédé de fabrication d'une carte de circuit imprimé souple multicouche selon la revendication 2, comprenant en outre :
un processus destiné à former des trous de masque ainsi qu'un motif de circuit sur ladite couche conductrice dans l'une desdites cartes de couches extérieures (6) ; et
un processus destiné à former des trous conducteurs dans ladite carte de couche intérieure (9) par un traitement au laser en utilisant lesdits trous de masque après avoir stratifié ladite carte de couche intérieure (9) et lesdites cartes de couches extérieures (6).
